# FASCICULE DE BREVET EUROPEEN

(11) **EP 1 168 240 B1**
(45) Date de publication et mention de la délivrance du brevet: **26.10.2005**
(21) Numéro de dépôt: 01117497.6
(22) Date de dépôt: 09.03.1998
(51) Int. Cl.: G06K 19/06, G06K 19/077

(54) **Connexion par dépôt de substance visqueuse épousant le relief**
Verbindung durch Aufbringen eines dem Relief entsprechenden viskosen Produktes
Connection by depositing a viscous material following the relief shape

(30) Priorité: 27.03.1997 FR 9704094
(43) Date de publication de la demande: 02.01.2002
(62) Demande divisionnaire de: 98914903.4
(73) Titulaire: GEMPLUS, 13420 Gémenos (FR)
(72) Inventeur: Patrice, Philippe, 13190 Allauch (FR); Zafrany, Michael, 13006 Marseille (FR)

(56) Documents cités:
- EP-A- 0 637 841
- DE-U- 9 315 652
- US-A- 4 999 136
- US-A- 5 423 889

## Description

L'invention concerne un procédé de fabrication de modules électroniques, notamment destinés à être montés dans un dispositif électronique sous forme de carte, lesdits modules comprenant un support comportant au moins une face munie de pistes de contact et un microcircuit qui est fixé sur ce support et qui comporte des plots de sortie reliés chacun à une piste de contact du support.

De tels dispositifs sous forme de carte comprennent, en particulier, les cartes à circuit(s) intégré(s), aussi appelées cartes à puce, mais aussi des supports d'éléments électroniques pour la télévision, les magnétoscopes, etc.

Une carte à puce est constituée d'un corps de carte et d'un module comprenant la puce et intégré dans le corps de carte.

Un module de carte à puce est constitué d'un support, généralement en verre époxy, qui est métallisé sur une face de manière à présenter des pistes de contact et d'une puce qui est collée sur l'autre face du support et qui comporte des plots de sortie sur sa face extérieure. Des puits de connexion sont aménagés à travers le support pour le passage de fils de connexion reliant un plot de sortie à une piste de contact.

Les fils de connexion, en métal inoxydable tel que l'or ou de l'aluminium, sont soudés en utilisant différentes technologies, telles que le soudage par ultrasons ou par thermocompression, qui nécessitent un enrobage ("glob top") ultérieur des fils de connexion au moyen d'une résine pour les protéger. Il est parfois nécessaire de fixer préalablement une barrière de retenue de la résine, telle qu'un anneau métallique ou en silicone, sur le support.

La masse d'enrobage est déposée de manière non contrôlable et, lorsqu'elle est polymérisée, elle forme une goutte de grande épaisseur qui dépasse en hauteur les spécifications des cartes à puce. Il est donc nécessaire d'effectuer une opération de fraisage pour réduire l'épaisseur du module à la valeur requise. Cette opération de fraisage peut endommager le module, ce qui constitue la cause principale des rebuts de fabrication.

Dans le corps de la carte à puce, on aménage une cavité qui est destinée à recevoir le module et qui doit être relativement profonde pour recevoir un module de hauteur importante. Il en résulte que l'épaisseur du corps de la carte au niveau de la cavité est faible, ce qui provoque, lorsque la carte à puce subit des flexions, une déformation importante du corps de la carte qui limite la fiabilité et la durée de vie de la carte.

De plus, la polymérisation de cette goutte de résine provoque un phénomène de bombement du module.

Ce bombement peut entraîner une détérioration des lecteurs de carte à puce.

Le problème à la base de l'invention est de fournir un module électronique de hauteur réduite de manière à supprimer les inconvénients précités.

D'autres techniques connues décrites dans DE-A-4325458, DE-A-4441052 et JP-A-08039974 décrivent les caractéristiques du préambule de la revendication 1 ainsi que l'utilisation d'une substance adhésive pour connecter les pistes du support aux plots d'un microcircuit. Dans DE-A-4325458 et DE-A-4441052, la substance adhésive a la forme d'une gouttelette et ne touche que les plots de sortie et les pistes de contact. Dans JP-A-08039974, elle a la forme d'un film adhésif conducteur.

Le document JP-A-07099267 décrit une puce avec une connexion en pâte imprimée conductrice, exposées dans un plan commun.

Le document US-A-4792843 décrit une puce retournée en "Flip-Chip".

Le document JP-A-09245698 décrit la formation d'un film conducteur entre une paire d'électrodes en appliquant des gouttelettes d'une solution de matériau formant encre conductrice.

Le document EP-A-0637 841 de HITACHI décrit un procédé de fabrication d'un dispositif pour cartes à puce comportant plusieurs semiconducteurs, et dans lequel des connexions entre les plots de sortie des semiconducterus et les pistes de contact du support sont réalisées à l'aide d'une pâte conductrice, appliquée par sérigraphie, ce qui pose, notamment, des problèmes d'adhésion de la pâte conductrice au relief du dispositif semiconducteur.

Le document US-A-4 999 136 de Westinhouse décrit une substance conductrice adhésive pouvant être appliquée pendant des opérations de microcâblage, par dispense au moyen d'une seringue automatisée.

L'invention vise à pallier les problèmes des techniques connues.

A cet effet, elle a pour objet un procédé et une installation selon les revendications.

Ces connexions ne nécessitent pas d'enrobage de protection, ce qui permet de réduire notablement la hauteur du module. Il en résulte que la fabrication est simplifiée et que, en particulier, l'opération de fraisage est supprimée, ce qui réduit fortement le taux de rebuts de fabrication.

Avantageusement, la substance conductrice est une colle conductrice isotrope.

Des puits de connexion du support sont remplis par la substance conductrice.

Le support peut comporter deux faces munies de pistes de contact.

Avantageusement, une des faces du support est recouverte par un film adhésif activable.

Ceci constitue une protection supplémentaire du microcircuit et permet de simplifier l'opération de fixation du module dans le corps de la carte.

Les plots de sortie du microcircuit peuvent comporter des bosses de connexion de manière à réduire la résistance de contact.

D'autres caractéristiques et avantages de l'invention apparaîtront à la lecture de la description détaillée et aux dessins annexés dans lesquels :
- la figure 1 est un schéma qui représente, en section transversale, un module électronique de type connu ;
- la figure 2 représente un module électronique obtenu à l'aide du procédé conforme à la présente invention ;
- la figure 3 est une vue de dessus d'un mode de réalisation d'un module dont le support comporte deux faces munies de pistes de contact ;

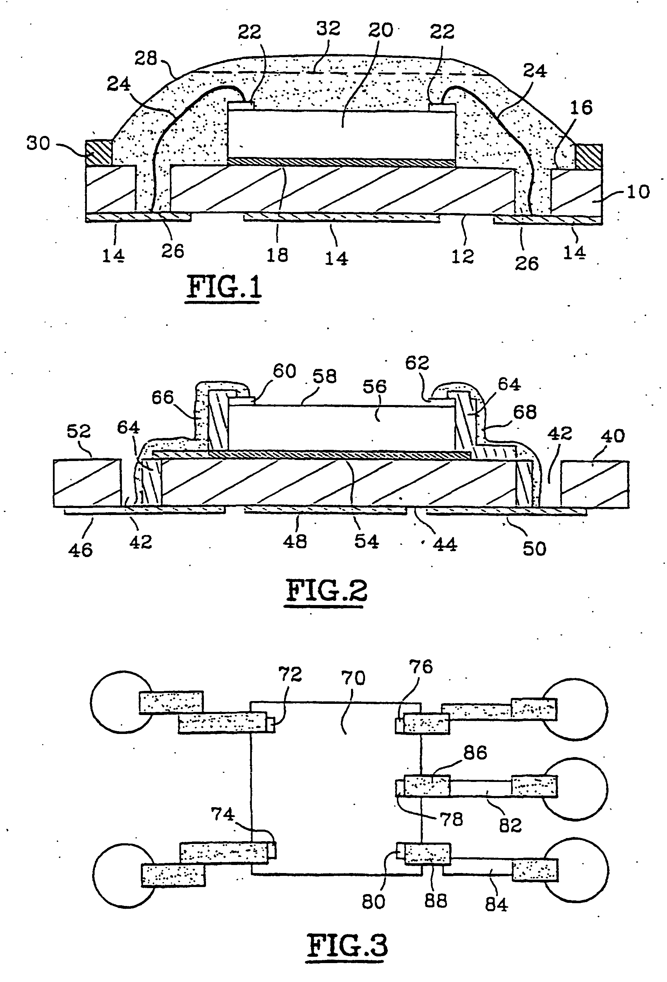

La figure 1 représente un module électronique de type connu.

Il comprend un support 10, par exemple en verre époxy. Une de ses faces 12 comporte des pistes de contact 14 réalisées par métallisation. L'autre face 16 comporte une couche de colle 18 servant à fixer la face inférieure d'un microcircuit 20 qui comporte des plots de sortie 22 sur sa face supérieure libre.

Les connexions entre les plots de sortie 22 et les pistes de contact 14 sont réalisées par soudage de fils métalliques 24 qui passent chacun à travers un puits 26 de connexion réalisé dans le support 10. Après l'opération de soudure des fils 24, ceux-ci sont enrobés d'une résine polymérisable qui forme une goutte 28 qui est retenue par un anneau périphérique 30 en silicone.

Cette goutte 28 est appliquée de manière non contrôlée et elle présente une épaisseur importante qui augmente considérablement la hauteur du module si bien qu'il est nécessaire d'araser sa partie supérieure par une opération d'usinage, tel qu'un fraisage, comme schématisé par la ligne en pointillés 32.

Comme indiqué plus haut, la présence de cette goutte 28 peut réduire la résistance mécanique de la carte à puce au niveau de la cavité recevant le module de telle sorte que la résistance mécanique de la carte à ce niveau est insuffisante et que, en outre, la carte peut présenter un bombement à ce niveau.

La figure 2 représente un module électronique issu du procédé de fabrication selon l'invention. Le support 40 comporte des puits de connexion 42. La face inférieure 44 du support 40 est métallisée et comporte des pistes de contact 46, 48 et 50. La face supérieure 52 du support 40 porte une couche 54 de colle servant à la fixation d'une puce 56 qui comporte, sur sa face supérieure 58, des plots de sortie 60 et 62 qui peuvent être munis de bosses de contact (bumps) non représentées. Un revêtement 64 d'adhésif isolant est appliqué sur la périphérie de la puce 56, sur la face 52 du support au voisinage de la puce et dans les puits de connexion 42.

Conformément à l'invention, les connexions 66 et 68 entre les plots de sortie 60 et 62 et les pistes de contact 46 et 50 sont constitués par un cordon de substance conductrice adhésive qui épouse le relief du support, plus particulièrement qui est en contact avec le revêtement adhésif 64 et dont les extrémités sont en contact le plot de sortie et la piste de contact associée. Cette substance est appliquée à l'état visqueux.

L'application de cette substance, par exemple une colle conductrice isotrope, est réalisée par une technique de dépôt dite de "dispense" selon laquelle on applique une substance liquide ou de faible viscosité au moyen d'une seringue à débit et ouverture commandés.

Cette opération de dispense est réalisée par exemple au moyen d'une installation commercialisée sous la dénomination CAM/ALOT par la société américaine Camelot Systems Inc. et utilisée pour la réalisation en ligne de circuits électroniques. Le déplacement et l'ouverture de la seringue sont commandés par un programme informatique.

Pour améliorer le contact électrique, les plots de sortie peuvent comporter des bossages de contact et le contact des extrémités des cordons de substance conductrice se fait avec ces derniers.

L'invention s'applique aussi au cas où le support comporte deux faces métallisées comportant des pistes de contact.

Ceci est illustré sur la figure 3 qui est une vue partielle de dessus du module où l'on voit une puce 70 avec ses plots de sortie 72, 74, 76, 78 et 80. Les plots 72, 74 et 76 sont reliés à une piste de contact de la face inférieure du support et les plots 78 et 80 sont reliés à une piste 82, respectivement 84, disposée sur la face supérieure du support, également par un cordon de substance conductrice adhésive 86, respectivement 88.

Le module électronique peut être recouvert par un film adhésif activable, par exemple par chauffage ou rayonnement ultraviolet, afin, d'une part, d'augmenter la protection de la puce et, d'autre part, de simplifier l'opération de fixation du module dans la cavité du corps de carte.

La réalisation de connexions directes selon la présente invention s'applique à la fabrication de tout dispositif électronique sous forme de carte tel que les cartes de commande d'appareils vidéo ou d'appareils ménagers.

On voit que l'invention permet de supprimer l'enrobage des connexions et, par suite, de réduire l'épaisseur des modules.

Par ailleurs, les résines utilisées comme substance conductrice sont très souples, ce qui augmente la fiabilité du module.

Les opérations liées à l'enrobage des connexions, à savoir la mise en place d'une barrière de retenue telle qu'un anneau de silicone, le dépôt de la résine d'enrobage et l'usinage de la goutte de résine, sont supprimées. Il en résulte une simplification de la fabrication et une réduction du coût de fabrication.

L'invention permet d'avoir une épaisseur du corps de carte plus importante au niveau du module et, par conséquent, d'accroître la résistance mécanique de la carte.

Grâce à l'invention, on peut réduire les dimensions des modules dans le plan du microcircuit, ce qui permet de fabriquer les modules en chaîne avec deux lignes adjacentes de modules.

Enfin, l'invention permet de supprimer le phénomène de bombement et, par suite, d'éviter la détérioration des lecteurs.

## Revendications

1. Procédé de fabrication d'un module électronique destiné à un dispositif électronique; ce procédé comportant les étapes consistant à : prévoir un support (40) avec une face inférieure (44) métallisée comportant des pistes de contact (46 ; 48 ; 50) ; prévoir une puce (56 ; 70) qui comporte sur une face supérieure (58) des plots de sortie (60 ; 62); fixer sur une face supérieure (52) du support (40) la puce (56 ; 70) par sa face inférieure (44) ; et réaliser des connexions (66, 68 ; 86, 88) des plots de sortie (60 ; 62) aux pistes de contact (46 ; 48 ; 50) ; **caractérisé en ce que** l'étape de réalisation des connexions (66, 68 ; 86, 88) est effectuée par dépôt d'un cordon de substance conductrice visqueuse au moyen d'une seringue, entre les plots de sortie (60 ; 62) et les pistes de contact (46; 48 ; 50) et en épousant le relief de la puce (56 ; 70) et **en ce qu'**avant la réalisation des connexions (66, 68 ; 86, 88), un revêtement (64) d'adhésif isolant est appliqué sur la périphérie de la puce (56), sur la face (52) du support au voisinage de la puce et dans des puits de connexion (42) du support.

2. Procédé selon la revendication 1, **caractérisé en ce que** les cordons de connexion (66, 68 ; 86, 88) sont réalisés de manière à être en contact avec le revêtement adhésif isolant (64).

3. Procédé selon la revendication 1 ou 2, **caractérisé en ce que** les cordons de connexion (66, 68 ; 86, 88) ont leurs extrémités en contact avec les plots de sortie (60 ; 62) et les pistes de contact (46 ; 48 ; 50) associés.

4. Procédé selon l'une des revendications 1 à 3, **caractérisé en ce qu'**il comporte une étape où la face inférieure du support est métallisée pour comporter des pistes de contact.

5. Procédé selon l'une des revendications 1 à 4, **caractérisé en ce que** la face supérieure (52) du support (40) est pourvue d'une couche (54) de colle servant à la fixation de la puce (56 ; 70).

6. Procédé selon l'une des revendications 1 à 5, **caractérisé en ce qu'**avant la fixation de la puce (56 ; 70), sa face supérieure (58) est munie sur ses plots de sortie (60 ; 62) de bosses ou bossages de contact.

7. Procédé selon l'une des revendications 1 à 6, **caractérisé en ce que** la substance à l'état visqueux, est appliquée liquide ou dans un état de faible viscosité, au moyen d'une seringue à débit et ouverture commandés.

8. Procédé selon la revendication 7, **caractérisé en ce que** l'opération de dispense est réalisée au moyen d'une installation utilisée pour la réalisation en ligne de circuits électroniques, le déplacement et l'ouverture de la seringue sont commandés par un programme informatique.

9. Procédé selon l'une des revendications 1 à 8, **caractérisé en ce que** la puce (70) avec ses plots de sortie (72, 74, 76, 78, 80) est connectée avec des plots (72, 74, 76) reliés à une piste de contact de la face inférieure du support (40) et des plots (78, 80) reliés à une piste respective (82, 84), disposée sur la face supérieure du support par dépôt d'un cordon de substance conductrice adhésive respectif (86, 88).

10. Procédé selon l'une des revendications 1 à 9, **caractérisé en ce que** le module électronique est recouvert par un film adhésif activable, par exemple par chauffage ou rayonnement ultraviolet, afin d'augmenter la protection de la puce et de simplifier l'opération de fixation du module.

11. Procédé selon l'une des revendications 1 à 10, **caractérisé en ce que** la substance déposée à l'état visqueux, est une résine conductrice souple, ce qui augmente la fiabilité du module.

12. Procédé selon l'une des revendications 1 à 11, **caractérisé en ce que** le module est fabriqué en chaîne avec deux lignes adjacentes de modules.

13. Installation de fabrication d'un module électronique destiné à un dispositif électronique; cette installation comportant des moyens pour : prévoir un support (40) avec une face inférieure (44) métallisée comportant des pistes de contact (46 ; 48 ; 50) ; prévoir une puce (56 ; 70) qui comporte sur une face supérieure (58) des plots de sortie (60 ; 62); fixer sur une face supérieure (52) du support (40) la puce (56 ; 70) par sa face inférieure (44) ; et réaliser des connexions (66, 68 ; 86, 88) des plots de sortie (60 ; 62) aux pistes de contact (46 ; 48 ; 50) ; **caractérisée en ce que** l'installation comporte des moyens de réalisation des connexions (66, 68 ; 86, 88) par dépôt d'un cordon de substance conductrice visqueuse avec une seringue à débit et ouverture commandés, et des moyens pour appliquer un revêtement (64) d'adhésif isolant sur la périphérie de la puce (56), sur la face (52) du support au voisinage de la puce et dans des puits de connexion (42) du support.

14. Installation selon la revendication 13, **caractérisée en ce que** la seringue a une commande de débit et ouverture au contact des cordons de connexion (66, 68 ; 86 88) avec un revêtement adhésif (64).

15. Installation selon la revendication 13 ou 14, **caractérisée en ce que** la seringue a une commande de débit et ouverture au contact des cordons de connexion (66, 68 ; 86, 88) avec des puits de connexion (42).

16. Installation selon l'une des revendications 13 à 15, **caractérisée en ce qu'**elle comporte des moyens de métallisation de la face inférieure du support, pour former des pistes de contact.

17. Installation selon l'une des revendications 13 à 16, **caractérisée en ce qu'**elle comporte des moyens pour pourvoir la face supérieure (52) du support (40) d'une couche (54) de colle, et pour la fixation en se servant de cette colle, de la puce (56 ; 70).

18. Installation selon l'une des revendications 13 à 17, **caractérisée en ce qu'**elle comporte des moyens pour munir la puce (56 ; 70) sur ses plots de sortie (60 ; 62) de bosses ou bossages de contact.

19. Installation selon l'une des revendications 13 à 18, **caractérisée en ce qu'**elle comporte des moyens pour la réalisation en ligne de circuits électroniques et de dispense commandés par un programme informatique.

20. Installation selon l'une des revendications 13 à 19, **caractérisée en ce qu'**elle comporte des moyens d'augmentation de la protection de la puce et de simplification de l'opération de fixation du module qui recouvrent le module électronique d'un film adhésif activable, et des moyens d' activation, par chauffage et / ou rayonnement par exemple ultraviolet, de ce film.

21. Installation selon l'une des revendications 13 à 20, **caractérisée en ce qu'**elle comporte une chaîne de fabrication de module avec deux lignes adjacentes.

## Patentansprüche

1. Herstellungsverfahren eines für eine elektronische Vorrichtung bestimmten elektronischen Moduls; wobei dieses Verfahren die folgenden Stufen umfasst, bestehend aus: dem Vorsehen eines Trägers (40) mit einer metallisierten Unterseite (44) mit Kontaktspuren (46; 48; 50); dem Vorsehen eines Chips (56; 70), der auf einer Oberseite (58) Ausgangskontakte (60; 62) hat; dem Befestigen des Chips (56; 70) durch seine Unterseite (44) auf einer Oberseite (52) des Trägers (40); und Realisierung der Anschlüsse (66, 68; 86, 88) der Ausgangskontakte (60; 62) an den Kontaktspuren (46; 48; 50); **dadurch gekennzeichnet, dass** die Realisierungsstufe der Anschlüsse (66, 68; 86, 88) durch Aufbringen eines Gürtels einer zähflüssigen leitenden Substanz mittels einer Spritze zwischen den Ausgangskontakten (60; 62) und den Kontaktspuren (46; 48; 50) erfolgt und durch Übernahme des Reliefs des Chips (56; 70) und dass vor der Realisierung der Anschlüsse (66, 68; 86, 88) eine isolierende Haftbeschichtung (64) auf die Peripherie des Chips (56) auf der Seite (52) des Trägers in der Nähe des Chips und in den Anschlussvertiefungen (42) des Trägers angewendet wird.

2. Verfahren gemäß Anspruch 1, **dadurch gekennzeichnet, dass** die Anschlussgürtel (66, 68; 86, 88) derart realisiert werden, dass sie mit der isolierenden Haftbeschichtung in Kontakt stehen.

3. Verfahren gemäß Anspruch 1 oder 2, **dadurch gekennzeichnet, dass** die Enden der Anschlussgürtel (66, 68; 86, 88) mit den Ausgangsanschlüssen (60; 62) und den zugeordneten Kontaktspuren (46; 48; 50) in Kontakt stehen.

4. Verfahren gemäß Anspruch 1 bis 3, **dadurch gekennzeichnet, dass** es eine Stufe umfasst, in der die Unterseite des Trägers metallisiert wird, um Kontaktspuren zu umfassen.

5. Verfahren gemäß Anspruch 1 bis 4, **dadurch gekennzeichnet, dass** die Oberseite (52) des Trägers (40) mit einer zur Befestigung des Chips (56; 70) dienenden Klebeschicht (54) versehen ist.

6. Verfahren gemäß Anspruch 1 bis 5, **dadurch gekennzeichnet, dass** vor der Befestigung des Chips (56; 70) seine Oberseite (58) auf den Ausgangskontakten (60; 62) mit Buckeln oder Kontakthöckern versehen wird.

7. Verfahren gemäß Anspruch 1 bis 6, **dadurch gekennzeichnet, dass** die Substanz im zähflüssigen Zustand flüssig oder in einem Zustand geringer Viskosität mittels einer Spritze mit einstellbarem Durchsatz und einstellbarer Öffnung angewendet wird.

8. Verfahren gemäß Anspruch 7, **dadurch gekennzeichnet, dass** die Abgabeoperation mittels einer für die Online-Realisierung von elektronischen Schaltkreisen genutzte Installation realisiert wird, die Verschiebung und die Öffnung der Spritze durch ein Informatikprogramm gesteuert werden.

9. Verfahren gemäß Anspruch 1 bis 8, **dadurch gekennzeichnet, dass** der Chip (70) mit seinen Ausgangskontakten (72, 74, 76, 78, 80) mit den mit einer Kontaktspur der Unterseite des Trägers (40) verbundenen Kontakten (72, 74, 76) und mit einer jeweiligen auf einer Oberseite des Trägers durch Aufbringen eines jeweiligen Gürtels aus leitender Haftsubstanz (86, 88) angeordneten Spur (82, 84) verbundenen Kontakten (78, 80) in Kontakt steht.

10. Verfahren gemäß Anspruch 1 bis 9, **dadurch gekennzeichnet, dass** das elektronische Modul durch eine zum Beispiel durch Erhitzen oder ultraviolette Strahlung aktivierbare Haftfolie abgedeckt ist, um den Schutz des Chips zu erhöhen und die Befestigungsoperation des Moduls zu vereinfachen.

11. Verfahren gemäß Anspruch 1 bis 10, **dadurch gekennzeichnet, dass** die im zähflüssigen Zustand aufgebrachte Substanz ein elastisches leitendes Harz ist, was die Zuverlässigkeit des Moduls erhöht.

12. Verfahren gemäß Anspruch 1 bis 11, **dadurch gekennzeichnet, dass** das Modul am Fließband mit zwei anliegenden Linien von Modulen hergestellt wird.

13. Herstellungsanlage eines für eine elektronische Vorrichtung bestimmten elektronischen Moduls; wobei diese Anlage Mittel umfasst zum: Vorsehen eines Trägers (40) mit einer metallisierten Unterseite (44) mit Kontaktspuren (46; 48; 50); Vorsehen eines Chips (56; 70), der auf einer Oberseite (58) Ausgangskontakte (60; 62) umfasst; Befestigen des Chips 56; 70) durch seine Unterseite (44) auf einer Oberseite (52) des Trägers (40; und zum Realisieren der Anschlüsse (66, 68; 86, 88) der Ausgangskontakte (60; 62) an den Kontaktanschlüssen (46; 48; 50); **dadurch gekennzeichnet, dass** die Anlage Realisierungsmittel der Anschlüsse (66, 68; 86, 88) durch Aufbringen eines Gürtels einer zähflüssigen leitenden Substanz mit einer Spritze mit steuerbarem Durchsatz und steuerbarer Öffnung und Mittel zum Anwenden einer isolierenden Haftbeschichtung (65) auf der Peripherie des Chips (56) auf der Seite (52) des Trägers in der Nähe des Chips und in den Anschlussvertiefungen (42) des Trägers umfasst.

14. Anlage gemäß Anspruch 13, **dadurch gekennzeichnet, dass** die Spritze eine mit den Anschlussgürteln (66, 68; 86, 88) mit einer Haftbeschichtung (64) in Kontakt stehende Durchsatz- und Öffnungssteuerung hat.

15. Anlage gemäß Anspruch 13 oder 14, **dadurch gekennzeichnet, dass** die Spritze eine mit den Anschlussgürteln (66, 68; 86, 88) mit den Anschlussvertiefungen (42) in Kontakt stehende Öffnungs- und Durchsatzsteuerung hat.

16. Anlage gemäß Anspruch 13 bis 15, **dadurch gekennzeichnet, dass** sie Metallisierungsmittel der Innenseite des Trägers zur Bildung von Kontaktspuren umfasst.

17. Anlage gemäß Anspruch 13 bis 16, **dadurch gekennzeichnet, dass** sie Mittel umfasst, um die Oberseite (52) des Trägers (40) mit einer Klebeschicht (54) zu versehen und um den Chip (56; 70) unter Zuhilfenahme dieses Klebers zu befestigen.

18. Anlage gemäß Anspruch 13 bis 17, **dadurch gekennzeichnet, dass** sie Mittel umfasst, um den Chip (56; 70) auf seinen Ausgangsanschlüssen (60; 62) mit Buckeln oder Kontakthöckern zu versehen.

19. Anlage gemäß Anspruch 13 bis 18, **dadurch gekennzeichnet, dass** sie Mittel für die Online-Realisierung von elektronischen Schaltkreisen und zur durch ein Informatikprogramm gesteuerten Ausgabe umfasst.

20. Anlage gemäß Anspruch 13 bis 19, **dadurch gekennzeichnet, dass** sie Mittel zur Erhöhung des Schutzes des Chips und zur Vereinfachung der Befestigungsoperation des Moduls umfasst, die das elektronische Modul mit einer aktivierbaren Haftfolie beschichten und Mittel zur Aktivierung durch Erhitzen und / oder Bestrahlen dieser Folie, zum Beispiel durch UV.

21. Anlage gemäß Anspruch 13 bis 20, **dadurch gekennzeichnet, dass** sie ein Modulherstellungs-Fließband mit zwei anliegenden Linien umfasst.

## Claims

1. A method for manufacturing an electronic module intended for an electronic device, which method comprises steps consisting in: taking a support (40) with a metallic bottom face (44) comprising contact tracks (46; 48; 50); attaching a chip (56; 70) which comprises output contacts (60; 62) on its top face (58); fixing the chip (52; 70) by its bottom face (44) to the top face (52) of the support (40); and establishing connections (66, 68; 86, 88) between the output contacts (60; 62) and the contact tracks (46; 48; 50); **characterised in that** the step in which the connections (66, 68; 86, 88) are established is carried out by placing a line of a viscous conductive substance using a syringe between the output contacts (60; 62) and the contact tracks (46; 48; 50) and joining this with the raised pattern on the chip (56; 70), and **in that**, before establishing the connections (66, 68; 86, 88), a coating (64) of insulating adhesive is applied to the edges of the chip (56), on the face (52) of the support next to the chip and in the connection sockets (42) of the support.

2. A method according to claim 1, **characterised in that** the connection lines (66, 68; 86, 88) are made such that they are in contact with the coating (64) of insulating adhesive.

3. A method according to claim 1 or 2, **characterised in that** the ends of the connection lines (66, 68; 86, 88) are in contact with the output contacts (60; 62) and the related contact tracks (46; 48; 50).

4. A method according to any of the claims 1 to 3, **characterised in that** it comprises a step in which the bottom face of the support is metal-plated in order to comprise contact tracks.

5. A method according to any of the claims 1 to 4, **characterised in that** the top face (52) of the support (40) is provided with a layer (54) of glue that is used for attaching the chip (56; 70).

6. A method according to any of the claims 1 to 5, **characterised in that** before attaching the chip (56; 70), its top face (58) is provided with contact bumps on its output contacts (60; 62).

7. A method according to any of the claims 1 to 6, **characterised in that** the substance in viscous state is liquid or in a state of low viscosity when applied, by means of a syringe with controlled flow and opening.

8. A method according to claim 7, **characterised in that** the dispensing operation is carried out by means of a facility used for in-line manufacturing of electronic circuits; the movement and opening of the syringe are controlled by a computer program.

9. A method according to any of the claims 1 to 8, **characterised in that** the chip (70) with its output contacts (72, 74, 76, 78, 80) is connected to contacts (72, 74, 76) attached to a contact track on the bottom face of the support (40) and to contacts (78, 80) attached to respective tracks (82, 84) arranged on the top face of the support by placing respective lines of an adhesive conductive substance (86, 88).

10. A method according to any of the claims 1 to 9, **characterised in that** the electronic module is coated with an adhesive film that can be activated, such as by heating or ultraviolet radiation, in order to increase the protection of the chip and to simplify the operation of attaching the module.

11. A method according to any of the claims 1 to 10, **characterised in that** the substance applied in a viscous state is a flexible conductive resin, which increases the reliability of the module.

12. A method according to any of the claims 1 to 11, **characterised in that** the module is manufactured in a chain with two adjacent module lines.

13. A facility for manufacturing an electronic module intended for an electronic device; this facility comprises means for: taking a support (40) with a metallic bottom face (44) comprising contact tracks (46; 48; 50); taking a chip (56; 70) which comprises output contacts (60; 62) on its top face (58); attaching the chip (52; 70) by its bottom face (44) to the top face (52) of the support (40); and establishing connections (66, 68; 86, 88) between the output contacts (60; 62) and the contact tracks (46; 48; 50); **characterised in that** the facility comprises means for establishing connections (66, 68; 86, 88) by means of placing a line of a viscous conductive substance using a syringe with controlled flow and opening, and the means for applying a coating (64) of insulating adhesive to the edges of the chip (56) on the face (52) of the support next to the chip and in the connection sockets (42) of the support.

14. A facility according to claim 13, **characterised in that** the flow and opening of the syringe are controlled when the connection lines (66, 68; 86, 88) are in contact with an adhesive coating (64).

15. A facility according to claims 13 or 14, **characterised in that** the flow and opening of the syringe are controlled when the connection lines (66, 68; 86, 88) are in contact with the connection sockets (42).

16. A facility according to any of the claims 13 to 15, **characterised in that** it includes means for metal-plating the bottom face of the support in order to create contact tracks.

17. A facility according to any of the claims 13 to 16, **characterised in that** it comprises means for providing the top face (52) of the support (40) with a layer of glue, and for attaching the chip (56; 70) using this glue.

18. A facility according to any of the claims 13 to 17, **characterised in that** it comprises means for providing the output contacts (60; 62) of the chip (56; 70) with contact bumps.

19. A facility according to any of the claims 13 to 18, **characterised in that** it comprises means for in-line manufacturing of electronic circuits and for dispensing controlled by a computer program.

20. A facility according to any of the claims 13 to 19, **characterised in that** it comprises means for increasing the protection of the chip and simplifying the operation to attach the module, which involves coating the electronic module with an adhesive film that can be activated, as well as means for activating this film, such as by heating and/or ultraviolet radiation.

21. A facility according to any of the claims 13 to 20, **characterised in that** it comprises a module-manufacturing chain with two adjacent lines.
